# EUROPEAN PATENT SPECIFICATION

(11) **EP 3 809 808 B1**
(45) Date of publication and mention of the grant of the patent: **30.08.2023**
(21) Application number: 19821766.3
(22) Date of filing: 14.06.2019
(51) Int. Cl.: H05K 7/14, H05K 5/02, B60R 11/04, G01S 13/86, G01S 13/89, G01S 13/931, G01S 17/89, G01S 17/931

(54) **DEVICE OF INTELLIGENT SENSING SYSTEM**
VORRICHTUNG EINES INTELLIGENTEN SENSORSYSTEMS
DISPOSITIF DE SYSTÈME DE DÉTECTION INTELLIGENT

(30) Priority: 21.06.2018 CN 201820961341 U
(43) Date of publication of application: 21.04.2021
(73) Proprietor: Navinfo Co., Ltd., Beijing 100094 (CN)
(72) Inventor: HUANG, Weiyuan, Beijing 100094 (CN); SHI, Liangliang, Beijing 100094 (CN); ZHANG, Tengbo, Beijing 100094 (CN)
(74) Representative: Lam, Alvin
(86) International application number: PCT/CN2019/091206
(87) International publication number: WO 2019/242566

(56) References cited:
- CN-A- 101 858 744
- CN-A- 103 995 264
- CN-A- 103 995 264
- CN-A- 105 437 997
- CN-A- 105 437 997
- CN-A- 107 128 255
- CN-U- 202 782 968
- CN-U- 203 126 703
- CN-U- 203 126 703
- CN-U- 207 433 444
- CN-U- 208 572 631
- KR-A- 20060 001 038
- US-A- 4 300 271
- US-A1- 2011 026 772

## Description

### TECHNICAL FIELD

The present application relates to the technical field of map data acquisition, and relates to a device of a smart sensing system.

### BACKGROUND

Navigation electronic map is a significant bridge for applying positioning and navigation devices to people's lives, and is the foundation and key component of vehicle navigation systems and navigation databases. How to quickly obtain accurate road information data has become a hot spot for map data acquisition.

At present, a data acquisition device is usually mounted on a mobile carrier. However, the data acquisition device and the mobile carrier are two separate products, and the data acquisition device needs to be fixed on the mobile carrier. The data acquisition device is usually fixed to the mobile carrier via bolts and nuts, and the mounting and dismounting of the data acquisition device is troublesome and is of low efficiency.

CN107128255A discloses a sensor combinatory apparatus with laser radar, camera and GPS-antenna in a housing on top of a driverless vehicle collecting environmental data, where the sensor combinatory apparatus further includes a base plate support component which may be a guiderail so that the sensor mounting base plate may be movable on the guide rail in order to adapt the combinatory sensor apparatus in the present application to more vehicle models.

CN203126703U discloses a mobile measurement platform on a car roof, including a lidar, a panoramic camera, a GPS antenna and an inertial navigator.

CN103995264A discloses an on-board mobile laser radar mapping system, including a control system, and a terminal antenna and other development device, where the control system includes a GPS antenna, an inertia measuring unit, a central processor and data storage medium, a control panel and an external development interface.

CN202782968U discloses an on-board measure integrated system based on laser scanning and panorama images, including a car roof platform, an operation platform, a control assembly, a power supply system and a car wheel encoder, where the car roof platform includes a panorama camera, a laser radar and global position system (GPS) antennae, and the car roof platform further includes a sliding base and a sliding rail.

CN105437997A discloses the mounting of an on-board aluminum-electricity module power supply system, including housing, an aluminum-electricity module, a smart electric meter and a power controller.

CN207433444U discloses a solar car roof including a component bracket, where the component bracket is provided with at least two fixing apparatuses.

KR20060001038A discloses a device for adjusting the front and rear spacing of a cross bar, where a rail is fixed in parallel to the roof panel, and a sliding surface is formed on an upper surface of a rail main body along a length direction on a fixed rail part and a side surface of the fixed rail part.

US4300271A1 discloses a clamping device for a sliding mount, particularly a dove-tail mount, in which a guide projecting from a slide clock is slidably mounted in a guide groove of a guide body.

### SUMMARY

The present invention is defined by the device of independent claim 1. Additional features of the invention are presented in the dependent claims. Embodiments according to the claimed invention provide a device of a smart sensing system, including: a base and a data collection apparatus; the data acquisition device includes a housing, a detection radar, a camera, an universal serial bus (USB) port, a wireless fidelity (wifi) antenna, a global position system (GPS) antenna, an inertial navigation system and a main board, and the inertial navigation system and the main board are provided in the housing; the wifi antenna, the GPS antenna, the detection radar and the camera are provided on the housing, and the wifi antenna, an output end of the detection radar and an output end of the camera are communicatively connected to the main board, respectively; the GPS antenna is communicatively connected to an input end of the inertial navigation system, and an output end of the inertial navigation system is communicatively connected to input ends of the camera and the detection radar; the USB port is provided on the housing and is communicatively connected to a memory on the main board; a bottom of the housing is provided with at least one guide rail; a top of the base is provided with a guide groove that fits the guide rail, a side wall of the guide groove is provided with a locking means, the guide rail is mounted in the guide groove, and the guide rail is locked in the guide groove by the locking means.

Optionally, the guide groove is a dovetail groove, and the guide rail is a trapezoidal guide rail. In embodiments according to the claimed invention, the base is provided with a sliding groove communicating with the guide groove, and is provided with means for fixedly mounting the base on a mobile carrier, e.g. a vehicle body; the locking means includes an adjusting handle, a first spring, and a sliding block mounted in the sliding groove in a sliding manner; the slider block is provided therein with a threaded hole and a first mounting hole, one end of the first spring is mounted in the first mounting hole, and the other end abuts against the base; the adjusting handle passes through the threaded hole and is connected to the base, and the sliding block is capable of moving into the guide groove and clamping a surface of the guide rail tightly after the adjusting handle is rotated.

Optionally, the device of the smart sensing system also includes a positioning means, the positioning means includes a positioning pin and a second mounting hole, the second mounting hole is provided on a side of the base and communicates with the guide groove, and the second mounting hole is located below a bottom surface of the guide groove; the positioning pin is inserted into the second mounting hole, and an insertion end of the positioning pin is provided with a protrusion protruding out of the bottom surface of the guide groove; a bottom surface of the guide rail is provided with an exit groove extending along a length direction of the guide rail, a side of the exit groove is provided with a notch communicating with the exit groove, and the protrusion is inserted into the notch and is slidable from the notch to the exit groove.

Optionally, an end of the guide groove is provided with a limit baffle.

Optionally, the wifi antenna is provided on a back, side or top of the housing, and the GPS antenna and detection radar are provided on the top of the housing.

Optionally, a bottom of the base is mounted fixedly on a roof of a vehicle body.

Further, the camera is provided at a position on a front of the housing such that an imaging range of the camera is not blocked by a front end of the vehicle body to facilitate obtaining road sign information.

Optionally, the housing is provided with herringbone heat dissipation holes.

Optionally, the device of the smart sensing system further includes a vehicle charger interface, a battery voltage display, a main board switch, and a main switch provided to the housing;
the vehicle charger interface, the battery voltage display and the main switch are connected to the battery, respectively, and the main board switch is connected to the main board.

Optionally, the device of the smart sensing system further includes a camera parameter adjusting apparatus communicatively connected to the camera.

Optionally, the housing is provided with a cable hole.

Optionally, a waterproof component is provided at the cable hole.

The device of the smart sensing system provided by the embodiments of the present disclosure includes a data acquisition device and a base, the bottom of the housing of the data acquisition device is provided with at least one guide rail, the top of the base is provided with a guide groove that fits the guide rail, a side wall of the guide groove is provided with a locking means, the guide rail is mounted in the guide groove, and the guide rail is locked in the guide groove by the locking means.

When the device of the smart sensing system needs to be mounted on the base, the base is fixedly mounted on a mobile carrier, then the guide rail of the data acquisition device is inserted into the guide groove of the base, and the data acquisition device is moved to a proper position, then the guide rail is locked in the guide groove by the locking means, so that the device of the smart sensing system can be quickly mounted on the mobile carrier. Moreover, when the data acquisition device needs to be dismounted from the mobile carrier, the guide rail is unlocked through the locking means, and then the data acquisition device can be dismounted from the mobile carrier, without dismounting the base from the mobile carrier, thereby improving the efficiency of dismounting the data acquisition device from the mobile carri er.

### BRIEF DESCRIPTION OF THE DRAWINGS

One or more embodiments are illustratively described by corresponding accompanying drawings. These illustrative description and drawings do not constitute a limitation on the embodiments, the embodiments of the invention being defined by the appended claims. Elements with the same reference numerals in the drawings are shown as similar elements, and the drawings do not constitute a scale limitation, where:
FIG. 1 is a schematic structural diagram of a device of a smart sensing system provided by an embodiment of the present disclosure;
FIG. 2 is a schematic structural diagram of a bottom of a data acquisition device provided by an embodiment of the present disclosure;
FIG 3 is a schematic structural diagram of a guide rail in FIG. 2;
FIG 4 is a schematic structural diagram of a base in FIG. 1;
FIG. 5 is a schematic structural diagram of a bottom of a data acquisition device provided by another embodiment of the present disclosure;
FIG. 6 is a structural sketch of a waterproof component provided by an embodiment of the present disclosure; and
FIG. 7 is a sketch of an internal structure of FIG. 6.

**Description of reference numerals:**

| | | | |
|---|---|---|---|
| 10 - | Housing; | 11 - | Vehicle charger interface; |
| 12 - | Battery voltage display; | 13 - | Main board switch; |
| 14 - | Main switch; | 15 - | Camera parameter adjusting apparatus; |
| 16 - | Herringbone heat dissipation hole; | 20 - | Detection radar; |
| 30 - | Camera; | 40 - | Wifi antenna; |
| 50 - | GPS antenna; | 60 - | USB port; |
| 70 - | Guide rail; | 71 - | Exit groove; |
| 72 - | Notch; | 80 - | Base; |
| 81 - | Guide groove; | 82 - | Sliding block; |
| 83 - | Limit baffle; | 84 - | Adjusting handle; |
| 85 - | Positioning pin; | 86 - | First spring; |
| 87 - | Second spring; | 90 - | Cable hole; |
| 100 - | Waterproof component; | 111 - | Connecting plate; |
| 112 - | Protrusion portion; | 1121 - | Second bolt hole; |
| 121 - | First sealing block; | 122 - | Second sealing block; |
| 1221 - | First bolt hole; | 123 - | First stop block; |
| 124 - | Second stop block; | 1241 - | Fourth bolt hole. |

### DESCRIPTION OF THE EMBODIMENTS

In order to enable a more thorough understanding on the features and technical content of the embodiments of the present disclosure, the implementation of the embodiments of the present disclosure will be described below in detail with reference to accompanying drawings. The accompanying drawings are only for reference and description, and are not used to limit the embodiments of the present disclosure. In the following technical description, for the convenience of explanation, a sufficient understanding of the disclosed embodiments is provided through various details. However, one or more embodiments can still be implemented without these details. The embodiments of the invention being defined by the appended claims.

In other cases, in order to simplify the drawings, well-known structures and apparatuses may be shown in a simplified manner.

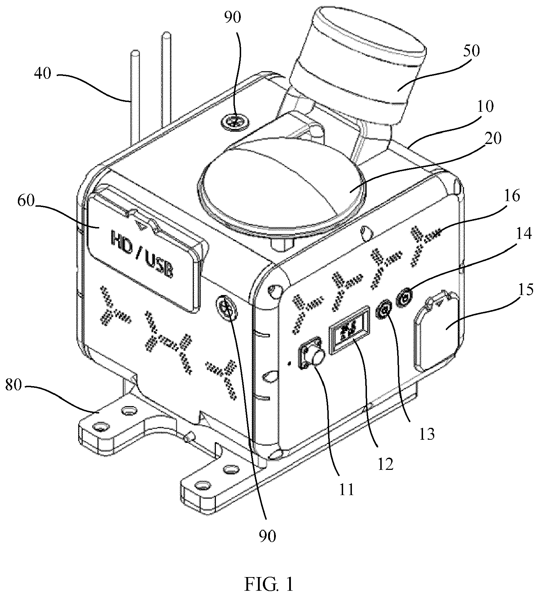

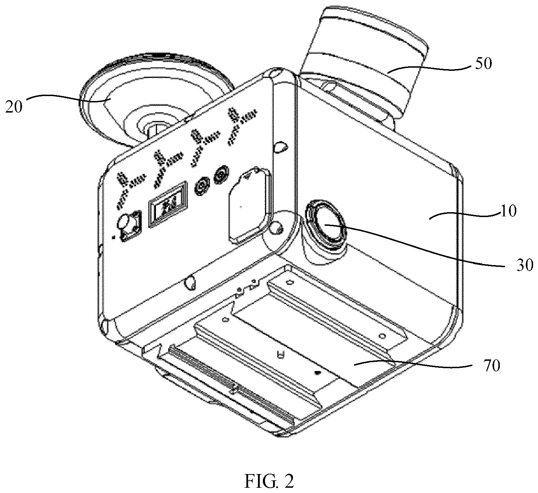

An embodiment of the present disclosure provides a device of a smart sensing system, the structure of which is shown in FIG. 1 and FIG. 2. The device of the smart sensing system includes a base 80 and a data acquisition device. The data acquisition device includes a housing 10, a detection radar 20, a camera 30, a wifi antenna 40, a GPS antenna 50, a USB port 60, an inertial navigation system and a main board. The inertial navigation system and the main board are provided in the housing 10. The wifi antenna 40, the GPS antenna 50, the detection radar 20 and the camera 30 are provided on the housing 10. The wifi antenna 40, an output end of the detection radar 20 and an output end of the camera 30 are communicatively connected to the main board, respectively. The GPS antenna 50 is communicatively connected to an input end of the inertial navigation system, and an output end of the inertial navigation system is communicatively connected to an input end of the camera 30 and an input end of the detection radar 20. The USB port 60 is provided on the housing 10 and is communicatively connected to a memory on the main board. A bottom of the housing 10 is provided with at least one guide rail 70, and a top of the base 80 is provided with a guide groove 81 that fits the guide rail 70. A side wall of the guide groove 81 is provided with a locking means. The guide rail 70 is mounted in the guide groove 81, and the guide rail 70 is locked in the guide groove 81 by the locking means.

Illustratively, the data acquisition device includes the housing 10, and the housing 10 has a cavity inside, and the main board, a battery, etc. are arranged in the cavity. The battery is used to supply power to power-needed elements, apparatuses and components in the device of the smart sensing system. The wifi antenna 40, the output end of the detection radar 20 and the output end of the camera 30 are communicatively connected to the main board, respectively. The GPS antenna 50 is communicatively connected to the input end of the inertial navigation system, and the output end of the inertial navigation system is communicatively connected to the input end of the camera 30 and the input end of the detection radar 20. The USB port 60 is provided on the housing 10 and is communicatively connected to the memory on the main board. The housing 10 is correspondingly provided with a cable hole 90 for a data transmission line to pass through.

In the embodiment, the inertial navigation system receives a Global Positioning System (GPS) signal or Global Navigation Satellite System (GNSS) signal transferred from the wifi antenna 40, and the GPS signal or the GNSS signal is distributed to the camera 30 and the detection radar 20 after being processed, where the signal distributed to the camera 30 contains time information, so that the camera 30 captures ground markings and signs of roads, and sends the captured data back to the memory of the main board after making a time stamp for the captured data, the captured data with the time stamp is sent back to the memory of the main board, and the information distributed by the above-mentioned inertial navigation system to the detection radar 20 includes time information and position information, so that a signal of the detection radar 20 that is reflected by a target has a time tag and coordinate data, and is transmitted to the memory of the main board. After data acquisition is completed, the data is exported through the USB port 60 of the housing 10. The wifi antenna 40 is in signal connection with the main board, and transmits a corresponding operation instruction received from a mobile control terminal to the main board, and working status of the camera 30, the wifi antenna 40 and the detection radar 20 is controlled by the main board.

At least one guide rail 70 is provided at the bottom of the housing 10, and the base 80 is provided with a guide groove 81 corresponding to the guide rail 70 at the bottom of the housing 10. In the embodiment, two parallel guide rails 70 are provided at the bottom of the housing 10, and the two guide rails 70 are provided on a bottom plate and fixed on the bottom of the housing 10 through the bottom plate. The base 80 is provided with two corresponding guide grooves 81, and a side wall of the guide grooves 81 is provided with a locking means, which locks the guide rail 70 onto the base 80 when the guide rails 70 are completely inserted into the guide grooves 81. The base 80 is fixed on a mobile carrier.

In some possible embodiments, a base may be fixed on a mobile carrier by a bolt, when a device of a smart sensing system needs to be mounted on the mobile carrier, the base is first fixedly mounted on the mobile carrier, then a guide rail of a data acquisition device is inserted into a guide groove of the base, and the data acquisition device is moved to a proper position, and then the guide rail is locked in the guide rail by the locking means, so that the device of the smart sensing system can be quickly mounted on the mobile carrier. Moreover, when the data acquisition device needs to be dismounted from the mobile carrier, the guide rail is unlocked through the locking means, and then the data acquisition device can be dismounted from the mobile carrier, without dismounting the base from the mobile carrier, thereby improving the efficiency of dismounting the data acquisition device from the mobile carrier.

The detection radar 20 provided by the embodiment may be a laser radar, which is a radar system that emits a laser beam to detect characteristic quantities such as position, speed and etc. of a target. It consists of a laser transmitter, an optical receiver, a turntable and an information processing system, etc. Its working principle is as follows: a detection signal (a laser beam) is transmitted to a target, then a received signal (target echo) reflected from the target is compared with the transmitted signal, and after proper processing, relevant information about the target can be obtained, such as parameters of the target including distance, azimuth, height, speed, attitude, and even shape, etc. Specifically in the application, laser is used as a signal source, a pulse laser emitted by the laser transmitter is scattered after arriving at trees, roads, bridges and buildings on the ground, and part of light waves will be reflected to the optical receiver of the laser radar, and a distance from the laser radar to a target point is obtained according to the principle of laser ranging. The pulse laser continuously scans a target object, and data of all target points on the target object can be obtained. After imaging processing on the data, an accurate three-dimensional model can be obtained.

There are various structural forms of the guide groove 81, and preferably, the guide groove 81 is a dovetail groove, and the guide rail 70 is a trapezoidal guide rail. Illustratively, two dovetail grooves are separately provided on the top of the base 80, the bottom of the data acquisition device is provided with trapezoidal slide rails that fit the dovetail grooves, the trapezoidal slide rails are in clearance fit with the guide grooves 81 to ensure that the guide rails 70 can be smoothly inserted into the guide grooves 81. The base 80 and the data acquisition device are mounted in a sliding manner by using the dovetail grooves and the trapezoidal guide rail, so that the relative movement of the two is stable, and the dovetail grooves can play a guiding and supporting role. In some possible embodiments, the housing of the data acquisition device may also be set as a dovetail groove at the bottom, and the base 80 is provided with a trapezoidal slide rail that fits the dovetail groove, on the top, and the data acquisition device is mounted on the trapezoidal slide rail of the base 80 through the dovetail groove, which also achieves the mounting of the data acquisition to the base 80 through the cooperation between the dovetail groove and the trapezoidal guide rail.

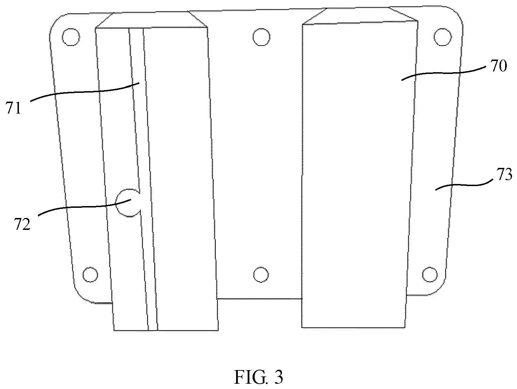

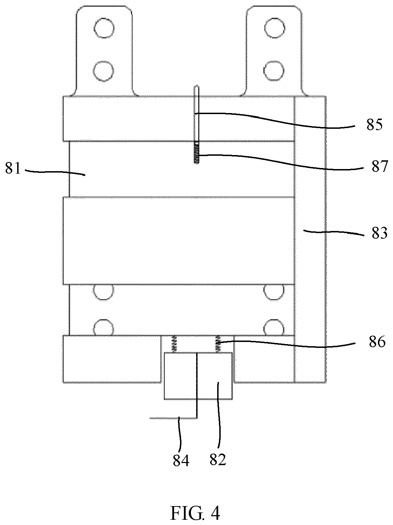

Please refer to FIG. 3 and FIG. 4, the base 80 is provided with a sliding groove communicating with the guide groove 81. The locking means includes an adjusting handle 84, a first spring 86 and a sliding block 82 that is mounted in the sliding groove in a sliding manner. The sliding block 82 is provided therein with a threaded hole and a first mounting hole, one end of the first spring 86 is mounted in the first mounting hole, and the other end abuts against the base 80. The adjusting handle 84 passes through the threaded hole and is connected to the base 80, and the sliding block 82 can move into the guide groove 81 after the adjusting handle 84 is rotated.

The locking means is provided in the sliding groove of the base 80. The locking means includes the adjusting handle 84, the two first springs 86 and the sliding block 82. The adjusting handle 84 includes a threaded mounting rod and a handle, and the threaded mounting rod is fixedly connected to the handle; for example, the threaded mounting rod and the handle are connected by welding or can be integrally formed by injection molding. The threaded hole is provided at a middle position of the sliding block 82, and two first mounting holes are arranged on both sides of the threaded hole. The two first springs 86 are mounted in the two first mounting holes, respectively, and the other ends of the two first springs 86 abut against the base 80, respectively. In some possible embodiments, in order to enhance the mounting stability of the first spring 86, the base 80 is provided with a counterbore near the mounting position of the first spring 86, that is, the other end of the first spring 86 is inserted into the counterbore of the base 80.

The sliding groove for mounting the sliding block 82 is formed by cutting along the side wall of the guide groove 81, and the sliding groove communicates with the guide groove 81. One end of the threaded mounting rod passes through the threaded hole on the sliding block 82 and is connected to the base 80, and two ends of the first spring 86 abut against in the first mounting hole of the sliding block 82 and the counterbore of the base 80, respectively. After the guide rail 70 is inserted into the guide groove 81, the handle is rotated to cause the sliding block 82 to further move into the guide groove 81 and clamp a surface of the guide rail 70 tightly, in order to enhance the clamping effect of the sliding block 82 on the guide rail 70. A shape of a holding surface of the sliding block 82 close to the guide rail 70 is similar to a shape of the side wall of the guide rail 70. When the slide rail needs to slide out of the guide groove 81, the handle is rotated to move the sliding block 82 away from the guide rail 70 and release the clamping of the sliding block 82 on the guide rail 70, so that the slide rail can slide out of the guide groove 81.

On the basis of the above-mentioned embodiment, the device of the smart sensing system further includes a positioning means, and the positioning means includes a positioning pin 85 and a second mounting hole. The second mounting hole is provided on a side of the base 80 and communicates with the guide groove 81, and the second mounting hole is located below a bottom surface of the guide groove 81. The positioning pin 85 is inserted into the second mounting hole, and an insertion end of the positioning pin 85 is provided with a protrusion protruding out of the bottom surface of the guide groove 81. The bottom surface of the guide rail 70 is provided with an exit groove 71 extending along a length direction of the guide rail 70. One side of the exit groove 71 is provided with a notch 72 communicating with the exit groove 71. The protrusion is inserted into the notch 72 and can slide from the notch 72 to the exit groove 71.

Illustratively, the base 80 is provided with the positioning means, the positioning means is used to prevent the guide rail 70 from sliding in the guide groove 81 after the guide rail 70 is mounted into the guide groove 81. The above-mentioned positioning means includes the positioning pin 85 and the second mounting hole, where the second mounting hole is provided on a side of the base 80 and communicates with the guide groove 81, that is, the second mounting hole is opened on one side of the base 80 and the opening position is located below the bottom surface of the guide groove 81 and extends below the bottom surface of the guide groove 81 toward the other side. The second mounting hole located below the guide groove 81 communicates with the guide groove 81. One end of the positioning pin 85 is inserted into the second mounting hole, and the other end is located outside the base. The end of the positioning pin 85 communicating with the guide groove 81 is provided with a protrusion protruding upward out of the bottom surface of the guide groove 81. A second spring 87 is provided between the protrusion and the base 80.

The bottom surface of the guide rail 70 is provided with the exit groove 71 extending along the length direction of the guide rail 70. One side of the exit groove 71 is provided with the notch 72 communicating with the exit groove 71, and the protrusion can be inserted into the notch 72 under an elastic force of the second spring 87 to lock the guide rail 70 in the guide groove 81. When the elastic force of the second spring 87 is overcome by an external force, the protrusion can be slid from the notch 72 into the exit groove 71 to release the locking between the guide rail 70 and the guide groove 81.

In some possible embodiments, the above-mentioned protrusion may be a pin with a thread at one end, and the pin is mounted on one end of the positioning pin 85 through the thread, and the second spring 87 is preloaded and mounted between the pin and the side wall of the second mounting hole, and the second spring 87 presses the pin to the edge of the second mounting hole on the bottom surface of the guide groove 81, and at this time, the pin can be inserted into the notch 72 of the guide rail 70.

When the guide rail 70 is mounted into the guide groove 81, the end of the positioning pin 85, which is outside the side wall of the guide groove 81, is pressed to overcome the elastic force of the second spring 87 and move the pin to the position of exit groove 71 of the guide rail 70, so that the guide rail 70 can be inserted into the guide groove 81. When the guide rail 70 is completely inserted into the guide groove 81, the notch 72 of the guide rail 70 is exactly above the edge of the second mounting hole, the press on the end of the positioning pin 85 is released, and the pin is inserted into the notch 72 under the action of the second spring 87, completing the limit to the guide rail 70.

If the guide rail 70 needs to be slid out of the guide groove 81, the end of the positioning pin 85, which is outside the side wall of the guide groove 81, is pressed, so that the pin enters the exit groove 71 of the guide rail 70, and the data acquisition device is dragged outwards to be dismounted from the base 80.

In order to prevent the guide rail 70 from escaping from the end of the guide groove 81 while being inserted and mounted, in this embodiment, a limit baffle 83 is provided at an end of the guide groove 81, so as to: first, restrict the guide rail 70 from escaping from the guide groove 81, and second, play a role of positioning when the guide rail 70 is inserted into the guide groove 81. Illustratively, the guide groove 81 of the base 80 is provided with the limit baffle 83 at an end away from an end for insertion end for the guide rail 70, and the limit baffle 83 is fixed to the end of the guide groove 81 by a bolt, or is fixed to the end of the guide groove 81 by welding. In the embodiment, the height of the limit baffle 83 is flush with the top of the base 80. When the guide rail 70 is inserted into the guide groove 81, the limit baffle 83 can abut against the bottom of the data acquisition device, so that dust can be prevented from entering the guide groove 81, and the guide rail 70 can also be provided with the largest blocking area.

In the embodiment, a traveling vehicle body is selected as the mobile carrier, and the bottom of the base 80 is fixedly mounted on the roof of the vehicle body. Illustratively, the bottom of the base 80 can be fastened to the roof of the vehicle body by bolts, and can also be mounted on a rack on the roof. In some possible embodiments, a mobile carrier may also be a drone, a bicycle, etc., and other suitable mobile carriers may also be selected according to an on-site data acquisition environment.

In the embodiment, the base 80 is fixedly mounted on the vehicle body, the camera 30 is provided at a position on the front of the housing 10 such that the camera 30 is not blocked by a front end of the vehicle body and position of road marking information can be obtained, where the road marking information includes information of markings and signs. The shooting angle of the fixed camera 30 is not affected by the front end of the vehicle body, and the camera can complete the information acquisition of road markings and signs, and can obtain clear map photos, thereby improving the accuracy of map data acquisition.

In a possible implementation, as shown in FIG. 2, the camera 30 is provided on the front of the housing 10.

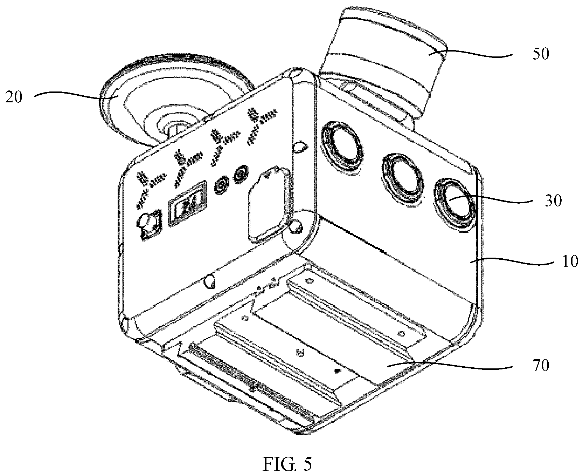

In another possible implementation, a plurality of cameras 30 may be provided on the front of the housing 10. The plurality of cameras 30 may be arranged in a line, which can expand the wide angle of taking pictures and expand the imaging range thereof. Or, the plurality of cameras 30 are distributed in a ring shape, to improve the accuracy of image capturing. For example, as shown in FIG. 5, three cameras 30 are provided on the housing 10, and the three cameras 30 are arranged in the same line, where two cameras 30 are located at the edge of the housing 10, and another camera 30 may be placed in the center.

On the basis of the above-mentioned embodiment, the wifi antenna 40 is provided on the back, side or top of the housing 10, and the GPS antenna 50 and the detection radar 20 are provided on the top of the housing. Illustratively, the GPS antenna 50 is mounted on the top of the housing 10 and connected to the inertial navigation system in the housing 10, and the GPS antenna 50 receives GPS signals and can transmit them to the inertial navigation system. The wifi antenna 40 is provided on a side of the housing 10 and is in signal connection to the main board of the housing 10. The wifi antenna 40 is used to receive operation instructions from the mobile control terminal and transmit them to the main board, so that the main board generates corresponding instructions and transmits them to other parts of the data acquisition device. The wifi antenna 40 can also wirelessly transmit data stored in the memory to other terminal devices. In some possible embodiments, the mounting position of a wifi antenna 40 in a housing 10 can be set on the back, side and top, as long as the mounting position facilitates signal receiving. The detection radar 20 is provided on the top of the housing 10, and there are no other structures of a vehicle body blocking around the detection radar 20, which can improve the accuracy of the surrounding data acquisition.

Please refer to FIG. 1, the housing 10 is provided with herringbone heat dissipation holes 16. The herringbone heat dissipation holes 16 are evenly distributed on both sides and back of the housing 10, and the heat generated by the main board and other components inside the housing 10 can be discharged via the herringbone heat dissipation hole 16, which is beneficial to reduce the temperature of the main board, increase the calculation speed of the main board, and improve the efficiency of map data acquisition.

Please refer to FIG. 1, the device of the smart sensing system further includes a vehicle charger interface 11, a battery voltage display 12, a main board switch 13 and a main switch 14 that are provided to the housing 10. The vehicle charger interface 11, the battery voltage display 12 and the main switch are connected to the battery, respectively, and the main board switch 13 is connected to the main board. Illustratively, the vehicle charger interface 11 is provided on a side of the housing 10, the vehicle charger interface 11 is connected to the battery inside the housing 10 and can be used as an interface for battery charging. The vehicle charger interface 11 can be connected to a cigarette lighter interface of a vehicle to use a vehicle battery to charge and power the battery of the data acquisition device, so that the working time of the map data acquisition device is not limited. Near the vehicle charger interface 11, the battery voltage display 12 is also provided, which is used to display the power of the battery in real time and remind a staff whether to charge the battery.

In addition, the housing 10 is also provided with the main board switch 13 used to control the on and off of a main board power supply line. Turning on the main board switch 13 can power on the main board to make the main board work; with the main board switch 13 being turned off, the main board is powered off, so that the mainboard is in a non-working state. After the map data acquisition is completed, the main board switch 13 can be turned off to extend the service life of the main board. The housing 10 is also provided with the main switch 14 used to control the on and off of a battery output line. With the main switch 14 being turned off, the data acquisition device is powered off and in a non-working state, which is convenient for controlling the working state of the entire data acquisition device. In some possible embodiments, the vehicle charger interface 11, the battery voltage display 12, the main board switch 13 and the main switch 14 may be arranged in a row on the same side of the housing 10, therefore, that side of the housing 10 can be used as a control panel, which not only facilitates the operation of the operator, but also makes the overall layout of the housing 10 more reasonable and beautiful.

Please refer to FIG. 1, the device of the smart sensing system further includes a camera parameter adjusting apparatus 15 that is communicatively connected to the camera 30. Illustratively, the camera parameter adjusting apparatus 15 is provided on the housing 10, and the camera parameter adjusting apparatus 15 is connected to the camera 30 through a data transmission line. The camera parameter adjusting apparatus 15 can adjust the brightness and focal length of the camera 30 while taking pictures, so that the photos captured by the camera 30 are clearer, and map data is acquired more accurately.

Please refer to FIG. 1, FIG. 6 and FIG. 7, the device of the smart sensing system further includes a cable hole 90 and a waterproof component 100 provided at the cable hole 90.

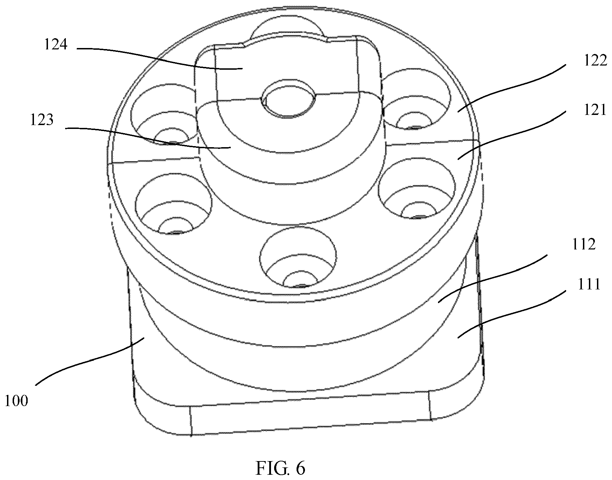

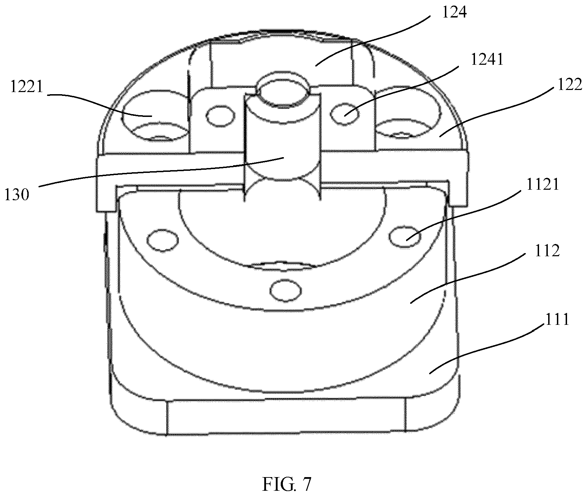

In an alternative implementation, as shown in FIG. 6 and FIG. 7, the waterproof component 100 includes a base and a sealing seat provided on the base. In the embodiment, the base may be made of a circular metal plate and a plastic plate. The base is provided with a first through-hole, which communicates with the cable hole 90. The base is mounted at the cable hole 90 of the housing, and can seal the cable hole 90 circumferentially. In the embodiment, the connection type of the base and the housing 10 is not limited, and the base may be glued to the housing 10, and a sealant or a sealing gasket or the like may be provided between the housing 10 and the base.

Specifically, as shown in FIG. 6 and FIG. 7, the base includes a connecting plate 111 for connecting with the housing 10 and a cylindrical protrusion portion 112 provided on the connecting plate 111, and the first through-hole vertically extends through the connecting plate 111 and the protrusion portion112.

The sealing seat includes a first sealing block 121 and a second sealing block 122 mounted opposite thereto. Both the first sealing block 121 and the second sealing block 122 are provided with a first bolt hole 1221, and the protrusion portion 112 is provided with a second bolt hole 1121. The first sealing block 121 and the second sealing block 122 are fixed on the protrusion 112 by bolts. The first sealing block 121 is also integrally formed with a first stop block 123, and the first stop block 123 is provided with a horizontally arranged third bolt hole. The second sealing block 122 is provided with a second stop block 124, and the second stop block 124 is provided with a fourth bolt hole 1241 horizontally extending through the second stop block 124. The first stop block 123 and the second stop block 124 are detachably connected by bolts. The sealing seat further includes a second through-hole vertically extending through the sealing seat, and the second through-hole is provided above the first through-hole and communicates with the first through-hole. Specifically, the first sealing block 121, the second sealing block 122, the first stop block 123 and the second stop block 124 are all provided with a semi-circular through-hole, and the second through-hole is formed after combining the semi-circular through-holes. The second through-hole is also provided therein with a sealing ring 130, and the first stop block 123 and the second stop block 124, when fixedly connected, can squeeze the sealing ring 130, thereby sealing a cable in the sealing ring 130.

When a cable needs to be led through the cable hole 90 to enter the inside of the housing 10, the second stop block 124 may be removed in advance, and after the cable passes through the sealing ring 130, the first through-hole and the cable hole 90, the second stop block 124 is fixed to the first stop block 123. By adjusting the installation depth of the fastening bolt in the first stopper 123, the cable is clamped and sealed between the first stop block 123 and the second stop block 124, which can effectively prevent rainwater or other liquid from entering the inside of the housing 10.

The waterproof component 100 provided by the implementation has good sealing performance, which can enable the entire device to have a higher waterproof level.

In another alternative implementation, when the requirement for waterproofing is not high, on the basis of the above-mentioned implementation, the protrusion portion 112, the first sealing block 121 and the second sealing block 122 may be omitted, and the first stop block 123 is directly disposed on the connecting plate 111 and connected to the second stop block 124. The structure of each component in the implementation is as described in the above-mentioned implementation, details are not described herein.

Compared with the above-mentioned implementation, the waterproof component 100 provided in the implementation can reduce the number and height of the parts and components of the waterproof component 100, thereby saving costs.

The device of the smart sensing system in the embodiments belongs to a mobile map data acquisition device, which is portable and easy to mount, and can be used in cooperation with lightweight work equipment, such as a tablet computer or a mobile phone. The device can not only be mounted on a vehicle, but also can meet the data acquisition needs of various scenarios through a drone, a bicycle, a backpack, etc. It will bring new solutions to map data acquisition for multiple industries, such as providing data support for overseas map acquisition, map crowdsourcing update, location aware, refined map service, advanced driver assistance system (ADAS) assisted driving, road network inspection, fatigue driving monitoring, etc.

The above-mentioned technical description may refer to the accompanying drawings, which form a part of the present application, and through the description, the accompanying drawings show implementations in accordance with the described embodiments. Although the embodiments are described in sufficient detail to enable those skilled in the art to implement the embodiments, the embodiments are nonrestrictive; therefore, other embodiments may be used, and changes may be made without departing from the scope of the invention, which is defined by the appended claims.

## Claims

1. A device of a smart sensing system, comprising a base (80) and a data acquisition device; wherein
the data acquisition device comprises a housing (10), a detection radar (20), a camera (30), an USB port (60), a wifi antenna (40), a GPS antenna (50), an inertial navigation system and a main board, the inertial navigation system and the main board are provided in the housing (10); the wifi antenna (40), the GPS antenna (50), the detection radar (20) and the camera (30) are provided on the housing (10), the wifi antenna (40), an output end of the detection radar (20) and an output end of the camera (30) are communicatively connected to the main board, respectively; the GPS antenna (50) is communicatively connected to an input end of the inertial navigation system, and an output end of the inertial navigation system is communicatively connected to input ends of the camera (30) and the detection radar (20); the USB port (60) is provided on the housing (10) and is communicatively connected to a memory on the main board;
a bottom of the housing (10) is provided with at least one guide rail (70), and a top of the base (80) is provided with a guide groove (81) that fits the guide rail (70); a side wall of the guide groove (81) is provided with a locking means; the guide rail (70) is mounted in the guide groove (81), and the guide rail (70) is locked in the guide groove (81) by the locking means;
the base (80) is provided with a sliding groove communicating with the guide groove (81), and is provided with means for fixedly mounting the base (80) on a mobile carrier, e.g. a vehicle body;
the locking means comprises an adjusting handle (84), a first spring (86), and a sliding block (82) mounted in the sliding groove in a sliding manner; the sliding block (82) is provided therein with a threaded hole and a first mounting hole, one end of the first spring (86) is mounted in the first mounting hole, and the other end abuts against the base (80); and
the adjusting handle (84) passes through the threaded hole and is connected to the base (80), and the sliding block (82) is capable of moving into the guide groove (81) and clamping a surface of the guide rail (70) tightly after the adjusting handle (84) is rotated.

2. The device of the smart sensing system according to claim 1, wherein the guide groove (81) is a dovetail groove, and the guide rail (70) is a trapezoidal guide rail.

3. The device of the smart sensing system according to claim 1, wherein the device of the smart sensing system further comprises a positioning means, the positioning means comprises a positioning pin (85) and a second mounting hole, the second mounting hole is provided on a side of the base (80) and communicates with the guide groove (81), and the second mounting hole is located below a bottom surface of the guide groove (81);
the positioning pin (85) is inserted into the second mounting hole, and an insertion end of the positioning pin (85) is provided with a protrusion protruding out of the bottom surface of the guide groove (81);
a bottom surface of the guide rail (70) is provided with an exit groove (71) extending along a length direction of the guide rail (70), a side of the exit groove (71) is provided with a notch (72) communicating with the exit groove (71), and the protrusion is inserted into the notch (72) and is slidable from the notch (72) to the exit groove (71).

4. The device of the smart sensing system according to claim 1, wherein an end of the guide groove (81) is provided with a limit baffle (83).

5. The device of the smart sensing system according to claim 1, wherein the wifi antenna (40) is provided on a back, side or top of the housing (10), and the GPS antenna (40) and the detection radar (20) are provided on the top of the housing (10).

6. The device of the smart sensing system according to claim 1, wherein a bottom of the base (80) is mounted fixedly on a roof of a vehicle body.

7. The device of the smart sensing system according to claim 6, wherein the camera (30) is provided at a position on a front of the housing (10) such that an imaging range of the camera (30) is not blocked by a front end of the vehicle body to facilitate obtaining road sign information.

8. The device of the smart sensing system according to claim 1, wherein the housing (10) is provided with herringbone heat dissipation holes (16).

9. The device of the smart sensing system according to claim 1, wherein the device of the smart sensing system further comprises a vehicle charger interface (11), a battery voltage display (12), a main board switch (13), and a main switch (14) provided to the housing (10);
the vehicle charger interface (11), the battery voltage display (12) and the main switch (14) are connected to a battery, respectively, and the main board switch (13) is connected to the main board.

10. The device of the smart sensing system according to claim 1, wherein the device of the smart sensing system further comprises a camera parameter adjusting apparatus (15) communicatively connected to the camera (30).

11. The device of the smart sensing system according to claim 1, wherein the housing (10) is provided with a cable hole (90).

12. The device of the smart sensing system according to claim 11, wherein a waterproof component (100) is provided at the cable hole (90).

## Patentansprüche

1. Vorrichtung eines intelligenten Sensorsystems mit einem Sockel (80) und einer Datenerfassungsvorrichtung, wobei
die Datenerfassungsvorrichtung ein Gehäuse (10), ein Erkennungsradar (20), eine Kamera (30), einen USB-Anschluss (60), eine WLAN-Antenne (40), eine GPS-Antenne (50), ein Trägheitsnavigationssystem und eine Hauptplatine umfasst, wobei das Trägheitsnavigationssystem und die Hauptplatine in dem Gehäuse (10) vorgesehen sind, wobei die WLAN-Antenne (40), die GPS-Antenne (50), das Erkennungsradar (20) und die Kamera (30) an dem Gehäuse (10) vorgesehen sind, wobei die WLAN-Antenne (40), ein Ausgangsende des Erkennungsradars (20) beziehungsweise ein Ausgangsende der Kamera (30) zur Kommunikation mit der Hauptplatine verbunden sind, wobei die GPS-Antenne (50) zur Kommunikation mit einem Eingangsende des Trägheitsnavigationssystems und ein Ausgangsende des Trägheitsnavigationssystems zur Kommunikation mit Eingangsenden der Kamera (30) und des Erkennungsradars (20) verbunden ist, wobei der USB-Anschluss (60) an dem Gehäuse (10) vorgesehen und zur Kommunikation mit einem Speicher auf der Hauptplatine verbunden ist,
ein Unterteil des Gehäuses (10) mit mindestens einer Führungsschiene (70) und ein Oberteil des Sockels (80) mit einer zu der Führungsschiene (70) passenden Führungsnut (81) versehen ist, wobei eine Seitenwand der Führungsnut (81) mit einem Arretiermittel versehen ist, wobei die Führungsschiene (70) in der Führungsnut (81) gelagert und die Führungsschiene (70) mithilfe des Arretiermittels in der Führungsnut (81) arretiert ist, der Sockel (80) mit einer Gleitnut, die mit der Führungsnut (81) in Verbindung steht, und mit Mitteln zum Befestigen des Sockels (80) an einem mobilen Träger, z.B. einer Fahrzeugkarosserie, versehen ist,
das Arretiermittel einen Stellgriff (84), eine erste Feder (86) und ein Gleitstück (82) umfasst, das verschiebbar in der Gleitnut gelagert ist, wobei das Gleitstück (82) mit einem Gewindeloch und einem ersten Montageloch versehen ist, wobei ein Ende der ersten Feder (86) in dem ersten Montageloch angebracht ist und das andere Ende an dem Sockel (80) anliegt, und
der Stellgriff (84) durch das Gewindeloch verläuft und mit dem Sockel (80) verbunden ist und sich das Gleitstück (82) in die Führungsnut (81) bewegen und eine Fläche der Führungsschiene (70) festklemmen kann, wenn der Stellgriff (84) gedreht wurde.

2. Vorrichtung des intelligenten Sensorsystems nach Anspruch 1, wobei es sich bei der Führungsnut (81) um eine Schwalbenschwanznut handelt und bei der Führungsschiene (70) um eine trapezförmige Führungsschiene.

3. Vorrichtung des intelligenten Sensorsystems nach Anspruch 1, wobei die Vorrichtung des intelligenten Sensorsystems ferner ein Positioniermittel umfasst, das einen Positionierstift (85) und ein zweites Montageloch umfasst, wobei das zweite Montageloch an einer Seite des Sockels (80) vorgesehen ist und mit der Führungsnut (81) in Verbindung steht und sich unterhalb einer unteren Fläche der Führungsnut (81) befindet,
der Positionierstift (85) in das zweite Montageloch eingeführt und ein Einführende des Positionierstifts (85) mit einem Vorsprung versehen ist, der aus der unteren Fläche der Führungsnut (81) vorsteht,
eine untere Fläche der Führungsschiene (70) mit einer Auswurfnut (71) versehen ist, die in einer Längsrichtung der Führungsschiene (70) verläuft, wobei eine Seite der Auswurfnut (71) mit einer Aussparung (72) versehen ist, die mit der Auswurfnut (71) in Verbindung steht, und der Vorsprung in die Aussparung (72) eingeführt und von der Aussparung (72) aus zur Auswurfnut (71) verschiebbar ist.

4. Vorrichtung des intelligenten Sensorsystems nach Anspruch 1, wobei ein Ende der Führungsnut (81) mit einer Begrenzungsplatte (83) versehen ist.

5. Vorrichtung des intelligenten Sensorsystems nach Anspruch 1, wobei die WLAN-Antenne (40) an einer Rückseite, einer Seite oder einem Oberteil des Gehäuses (10) vorgesehen ist und die GPS-Antenne (40) und das Erkennungsradar (20) an dem Oberteil des Gehäuses (10) vorgesehen sind.

6. Vorrichtung des intelligenten Sensorsystems nach Anspruch 1, wobei ein Unterteil des Sockels (80) an einem Dach einer Fahrzeugkarosserie befestigt ist.

7. Vorrichtung des intelligenten Sensorsystems nach Anspruch 6, wobei die Kamera (30) in einer Position an einer Vorderseite des Gehäuses (10) vorgesehen ist, so dass ein Bilderzeugungsbereich der Kamera (30) nicht durch ein vorderes Ende der Fahrzeugkarosserie blockiert ist und somit Straßenschildinformationen erfasst werden können.

8. Vorrichtung des intelligenten Sensorsystems nach Anspruch 1, wobei das Gehäuse (10) mit Wärmeableitlöchern (16) in einem Fischgrätmuster versehen ist.

9. Vorrichtung des intelligenten Sensorsystems nach Anspruch 1, wobei die Vorrichtung des intelligenten Sensorsystems ferner einen Fahrzeugladegerätanschluss (11), eine Batteriespannungsanzeige (12), einen Hauptplatinenschalter (13) und einen Hauptschalter (14) an dem Gehäuse (10) umfasst,
wobei der Fahrzeugladegerätanschluss (11), die Batteriespannungsanzeige (12) beziehungsweise der Hauptschalter (14) mit einer Batterie verbunden sind und der Hauptplatinenschalter (13) mit der Hauptplatine verbunden ist.

10. Vorrichtung des intelligenten Sensorsystems nach Anspruch 1, wobei die Vorrichtung des intelligenten Sensorsystems ferner eine Kameraparameteranpassungseinrichtung (15) umfasst, die zur Kommunikation mit der Kamera (30) verbunden ist.

11. Vorrichtung des intelligenten Sensorsystems nach Anspruch 1, wobei das Gehäuse (10) mit einem Kabelloch (90) versehen ist.

12. Vorrichtung des intelligenten Sensorsystems nach Anspruch 11, wobei an dem Kabelloch (90) eine wasserdichte Komponente (100) vorgesehen ist.

## Revendications

1. Dispositif d'un système de détection intelligent, comprenant une base (80) et un dispositif d'acquisition de données,
le dispositif d'acquisition de données comprenant un boîtier (10), un radar de détection (20), une caméra (30), un port USB (60), une antenne Wi-Fi (40), une antenne GPS (50), un système de navigation inertielle et une carte principale, le système de navigation inertielle et la carte principale étant situés dans le boîtier (10) ; l'antenne Wi-Fi (40), l'antenne GPS (50), le radar de détection (20) et la caméra (30) étant situés sur le boîtier (10), l'antenne Wi-Fi (40), une extrémité de sortie du radar de détection (20) et une extrémité de sortie de la caméra (30) étant connectées respectivement en communication à la carte principale ; l'antenne GPS (50) étant connectée en communication à une extrémité d'entrée du système de navigation inertielle, et une extrémité de sortie du système de navigation inertielle étant connectée en communication à des extrémités d'entrée de la caméra (30) et du radar de détection (20) ; le port USB (60) étant situé sur le boîtier (10) et étant connecté en communication à une mémoire sur la carte principale ;
un fond du boîtier (10) étant muni d'au moins un rail de guidage (70), et une partie supérieure de la base (80) étant munie d'une rainure de guidage (81) qui s'adapte au rail de guidage (70) ; une paroi latérale de la rainure de guidage (81) étant munie d'un moyen de verrouillage ; le rail de guidage (70) étant monté dans la rainure de guidage (81) et le rail de guidage (70) étant verrouillé dans la rainure de guidage (81) par le moyen de verrouillage ;
la base (80) étant munie d'une rainure de coulissement communiquant avec la rainure de guidage (81) et étant munie d'un moyen permettant de monter fixe la base (80) sur un support mobile, par exemple une carrosserie de véhicule ;
le moyen de verrouillage comprenant une poignée de réglage (84), un premier ressort (86) et un bloc coulissant (82) monté coulissant dans la rainure de coulissement ; le bloc coulissant (82) étant muni d'un trou fileté et d'un premier trou de montage, une extrémité du premier ressort (86) étant montée dans le premier trou de montage, et l'autre extrémité venant en butée contre la base (80) ; et
la poignée de réglage (84) passant à travers le trou fileté et étant reliée à la base (80), et le bloc coulissant (82) étant capable de se déplacer dans la rainure de guidage (81) et de serrer fermement une surface du rail de guidage (70) après la rotation de la poignée de réglage (84).

2. Dispositif du système de détection intelligent selon la revendication 1, dans lequel la rainure de guidage (81) est une rainure en queue-d'aronde, et le rail de guidage (70) est un rail de guidage trapézoïdal.

3. Dispositif du système de détection intelligent selon la revendication 1, le dispositif du système de détection intelligent comprenant en outre un moyen de positionnement, le moyen de positionnement comprenant une broche de positionnement (85) et un second trou de montage, le second trou de montage étant situé sur un côté de la base (80) et communiquant avec la rainure de guidage (81), et le second trou de montage étant situé sous une surface inférieure de la rainure de guidage (81) ;
la broche de positionnement (85) étant insérée dans le second trou de montage, et une extrémité d'insertion de la broche de positionnement (85) étant munie d'une protubérance faisant saillie hors de la surface inférieure de la rainure de guidage (81) ;
une surface inférieure du rail de guidage (70) étant munie d'une rainure de sortie (71) s'étendant selon une direction longitudinale du rail de guidage (70), un côté de la rainure de sortie (71) étant muni d'une encoche (72) communiquant avec la rainure de sortie (71), et la protubérance étant insérée dans l'encoche (72) et pouvant coulisser depuis l'encoche (72) vers la rainure de sortie (71).

4. Dispositif du système de détection intelligent selon la revendication 1, dans lequel une extrémité de la rainure de guidage (81) est munie d'un déflecteur de limite (83).

5. Dispositif du système de détection intelligent selon la revendication 1, dans lequel l'antenne Wi-Fi (40) est située sur un arrière, un côté ou un dessus du boîtier (10), et l'antenne GPS (40) et le radar de détection (20) sont situés sur le dessus du boîtier (10).

6. Dispositif du système de détection intelligent selon la revendication 1, dans lequel un fond de la base (80) est monté fixe sur un toit d'une carrosserie de véhicule.

7. Dispositif du système de détection intelligent selon la revendication 6, dans lequel la caméra (30) est située à une position à l'avant du boîtier (10) de sorte qu'une plage d'imagerie de la caméra (30) ne soit pas bloquée par une extrémité avant de la carrosserie de véhicule afin de faciliter l'obtention d'informations de signalisation routière.

8. Dispositif du système de détection intelligent selon la revendication 1, dans lequel le boîtier (10) est muni de trous de dissipation thermique (16) en chevron.

9. Dispositif du système de détection intelligent selon la revendication 1, le dispositif du système de détection intelligent comprenant en outre une interface de chargeur de véhicule (11), un module d'affichage de tension de batterie (12), un interrupteur de carte principale (13) et un interrupteur principal (14) situé sur le boîtier (10) ;
l'interface de chargeur de véhicule (11), le module d'affichage de tension de batterie (12) et l'interrupteur principal (14) étant connectés respectivement à une batterie, et l'interrupteur de carte principale (13) étant connecté à la carte principale.

10. Dispositif du système de détection intelligent selon la revendication 1, le dispositif du système de détection intelligent comprenant en outre un appareil de réglage de paramètres de caméra (15) connecté en communication à la caméra (30).

11. Dispositif du système de détection intelligent selon la revendication 1, dans lequel le boîtier (10) est muni d'un trou de câble (90).

12. Dispositif du système de détection intelligent selon la revendication 11, dans lequel un composant étanche à l'eau (100) est situé au niveau du trou de câble (90).
